(19) Europäisches Patentamt

European Patent Office

Office européen des brevets

(11) **EP 1 635 182 A1**

(12) **EUROPEAN PATENT APPLICATION**

(43) Date of publication:
**15.03.2006 Bulletin 2006/11**

(51) Int Cl.:
***G01R 19/25*** (2006.01)

(21) Application number: **04021457.9**

(22) Date of filing: **09.09.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(71) Applicant: **Rohde & Schwarz GmbH & Co. KG**
**81671 München (DE)**

(72) Inventors:
• **Hausdorf, Reiner**
**85521 Ottobrunn (DE)**

• **Brückner, Leo**
**62400 Brno (CZ)**

(74) Representative: **Körfer, Thomas et al**
**Mitscherlich & Partner,**
**Patent- und Rechtsanwälte,**
**Sonnenstrasse 33**
**80331 München (DE)**

(54) **Quasi-peak detector with inductor**

(57)    A quasi-peak detector (1) for detecting the weighted peak value (quasi peak) of the envelope of a signal ($S_{in}$) comprises a digital charging and discharging filter (11) which simulates the process of charging and discharging a capacitor ($C_1$). The digital charging and discharging filter (11) simulates charging through an inductor ($L_1$).

Fig. 6

EP 1 635 182 A1

**Description**

The invention relates to a so-called quasi-peak detector. Quasi-peak detectors serve to detect the weighted peak value of the envelope of a signal, for example of a baseband signal.

The quasi-peak detector transforms the envelope of an electrical noise voltage into an output signal level that is adapted to the psychophysical perceptual response of the human ear or human eye. The specification of such quasi-peak detectors can be found in "IEC CISPR 16-1/1999-10", "Specification of Radio Disturbance and Immunity Measuring Apparatus and Methods", Part 1: "Radio Disturbance and Immunity Measuring Apparatus". The human ear or human eye perceives interference pulses of the same amplitude to be the more disturbing the higher the rate of repetition of the interference pulses is. The purpose of a quasi-peak detector is to simulate this subjective perceptual response of the human ear or human eye.

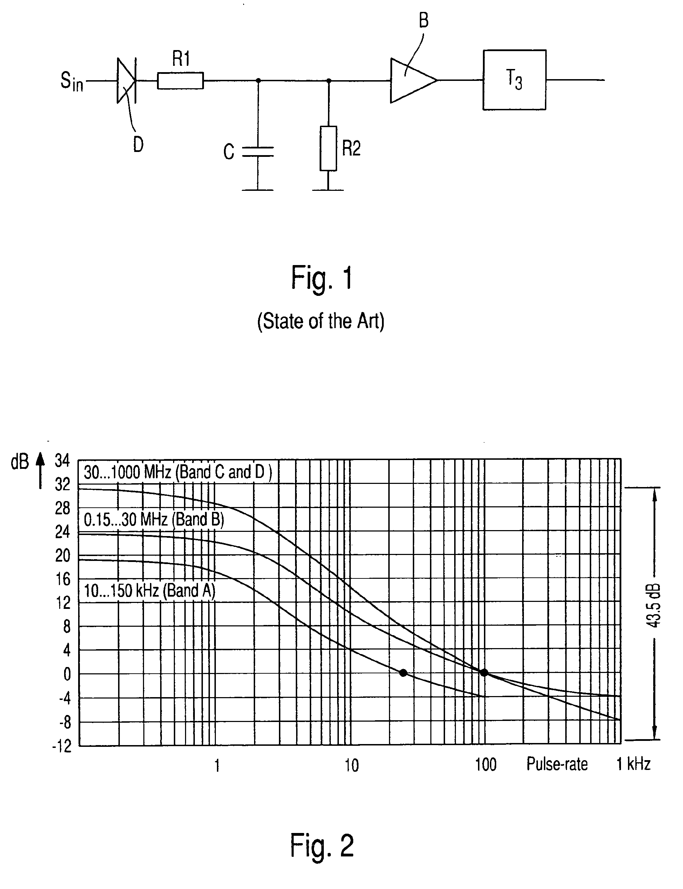

Fig. 2 shows the behaviour of a quasi-peak detector as demanded in the aforementioned specification. Represented is the level of the input-side noise voltage that is required in order to obtain an equal output level in each case at the output of the quasi-peak detector as a function of the pulse-rate (rate of repetition) of the noise voltage. In this figure it can be discerned that the quasi-peak detector requires a higher noise voltage at a low pulse-rate in order to obtain a certain output level than at a higher pulse-rate. In other words, the quasi-peak detector is more sensitive to noise voltages with a relatively high pulse-rate.

Quasi-peak detectors have previously been constructed in analogue design in a manner such as is evident from Fig. 1. The input signal $S_{in}$ is rectified at a diode D and supplied to a capacitor C via a charging resistor R1. During each half-wave of the input signal $S_{in}$ the capacitor C is consequently charged via the charging resistor R1. Discharge of the capacitor C is effected via a discharging resistor R2 connected parallel to the capacitor C. Downstream of the buffer B a measuring instrument, for example a moving-iron instrument, can be directly connected, this being implemented in this way mainly in the early days of quasi-peak measurements. In more recent times, evaluation has been made electronically by using an analogue low-pass filter $T_3$, which simulates the response of the measuring instrument and is connected downstream of the buffer B. Consequently the circuit has three time constants: a charging time constant $\tau_1$ = R1 · C, a discharging time constant $\tau_2$ = R2 · C and a damping time constant $\tau_3$ of the damping element $T_3$.

In connection with the analogue realisation of a quasi-peak detector the following problems arise: for an exact measurement the diode D has to be compensated. Due to of the large discharging time constant $\tau_2$, the capacitor has to be of high quality, i.e. it has to be able to retain the charge over a relatively long period (several seconds) without significant losses. As Fig. 2 shows, the sensitivity of the quasi-peak detector is specified differently for different frequency bands, so a different circuit has to be employed for each frequency band. Longterm stability and temperature stability are difficult to attain. Tuning of the detector and range-switching turn out to be difficult.

Thus in DE 101 03 481 A1 a digital charging filter which simulates the process for charging the capacitor, a digital discharging filter which simulates the process for discharging the capacitor, and a digital attenuating filter which simulates the attenuation response of the measuring instrument, are applied instead of the analogue components represented in Fig. 1. The digital realisation of the quasi-peak detector permits measurements to a high degree of precision. The digital charging filter and the digital discharging filter are implemented as first-order IIR (Infinite Impulse Response) filters. The digital attenuating filter is implemented as a second-order IIR (Infinite Impulse Response) filter and implements two critically coupled first-order low-pass filters. In this case two coefficients are identical. The digital input filter is likewise realised as a second-order IIR (Infinite Impulse Response) filter.

The quasi-peak detector disclosed in DE 101 03 481 A1 has the disadvantage of permanent switching of the digital filter between a charging period and a discharging period. Thus, a detector for detecting the charging period and the discharging period and a respective controller along with respective switching elements are necessary. Further, a special input filter for compensating negative effects resulting from the switching has to be arranged between the input of the device and the charging filter. Thus, the simulation results of the state of the art digital charging and discharging filter are not optimal although the circuitry is rather complex.

Thus, it is the object of the present invention to reduce the complexity of the charging, and discharging' filter. Especially, it is the object of the present invention to avoid switching between the charging period and the discharging period.

The object is solved by the features of claim 1.

According to the invention the digital charging and discharging filter simulates charging through an inductor. This gives improved simulation results and further avoids switching between the charging period and the discharging period.

The dependent claims contain advantageous further developments of the quasi-peak detector according to the invention.

With specific embodiments of the digital charging and discharging filter and of the optional digital attenuation filter arranged downstream of the digital charging and discharging filter the results of the simulation can be further improved.

By using specific values for the coefficient of the specific embodiments of the digital charging and discharging filter and of the digital attenuation filter as indicated in the dependent claims, the behaviour of the filter can be further optimised.

The invention will now be described in more detail with reference to the drawing. Shown in the drawing are:

Fig. 1    the basic structure of a quasi-peak detector of analogue design according to the state of the art;

Fig. 2    a diagram for the purpose of elucidating the sensitivity of the quasi-peak detector;

Fig. 3    an embodiment of the quasi-peak detector according to the state of the art in a first switching state;

Fig. 4    the state of the art embodiment of the quasi-peak detector represented in Fig. 3 in a second switching state;

Fig. 5    a block diagram of an embodiment of a quasi-peak detector according to the state of the art;

Fig. 6    a block diagram of an exemplary embodiment of a quasi-peak detector according to the invention;

Fig. 7    a realisation of the charging and discharging filter in the exemplary embodiment represented in Fig. 6 and

Fig. 8    a realisation of the attenuating filter of the exemplary embodiment represented in Fig. 6.

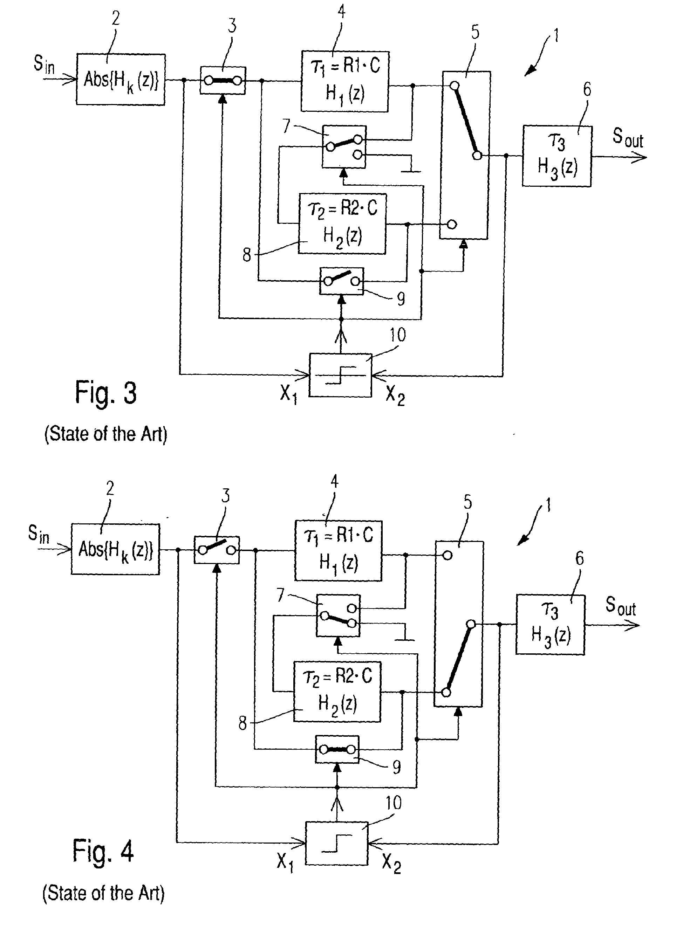

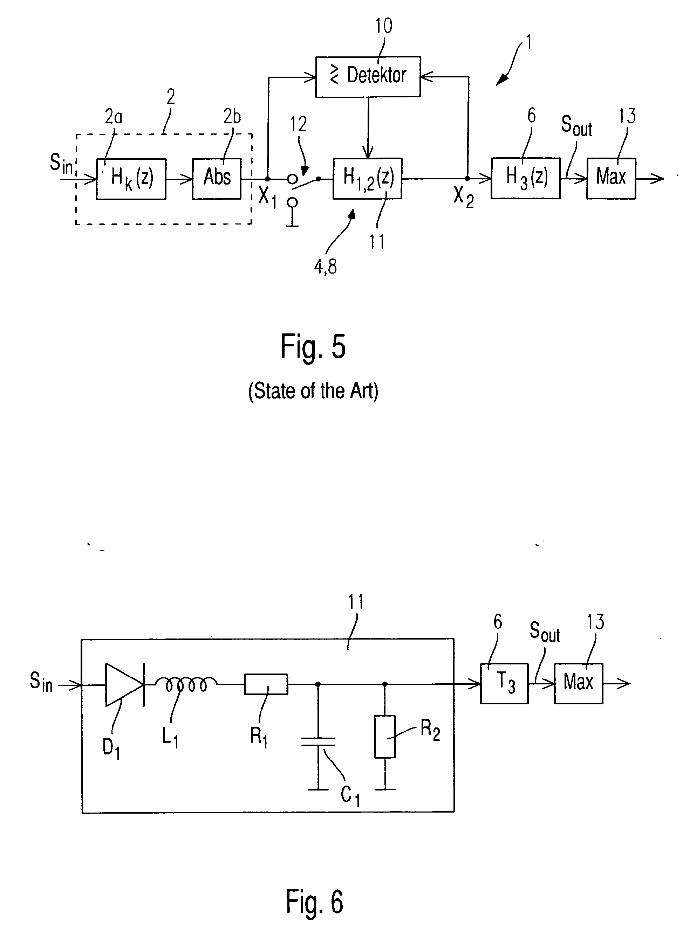

Fig. 3 shows an embodiment of a quasi-peak detector 1 according to DE 101 03 481 A1. The input signal $S_{in}$ is supplied to a digital input filter 2a (Fig. 5) having the transfer function $H_k(z)$. At the output of the digital input filter 2a there is found an absolute-value generator 2b (Fig. 5) is located which generates the absolute value of the output signal, so that the transfer function of the filter block 2 in which the input filter 2a and the absolute-value generator 2b are combined reads: abs $\{H_k(z)\}$.

The input filter 2 is connected to a digital charging filter 4 via a first switching element 3. The digital charging filter 4 has the transfer function $H_1(z)$ and simulates the process for charging the capacitor C with the time constant $\tau_1$ = R1 · C. The charging cycle of the quasi-peak detector 1 according to the invention is represented in Fig. 3. The output of the digital charging filter 4 is connected to a digital attenuating filter 6 via a second switching element 5. The digital attenuating filter 6 simulates the attenuation response of a measuring instrument with the time constant $\tau_3$ and has the transfer function $H_3(z)$. At the output of the attenuating filter 6 the output signal $S_{out}$ is available. The final value of the output at the end of the charging process is passed via a third switching element 7 to the digital discharging filter 8 which uses this final value as starting-value for the discharging cycle. In the course of the charging cycle represented in Fig. 3 the output of the discharging filter 8 is disconnected from the attenuating filter 6 by the switching element 5. Furthermore, a fourth switching element 9 is provided, via which the output of the discharging filter 8 is capable of being connected to the input of the charging filter 4. In the course of the charging cycle represented in Fig. 3, however, this switching element 9 is opened.

Furthermore, there is a control unit 10 which compares the output voltage $X_1$ of the filter 2 with the input voltage $X_2$ of the attenuating filter 6. If the voltage $X_1$ is greater than the voltage $X_2$, the circuit is in the charging cycle and the control unit 10 switches the switching elements 3, 5, 7 and 9 into the switching states represented in Fig. 3. If the voltage $X_2$ is greater than the voltage $X_1$, the circuit is in the discharging cycle and the switching elements 3, 5, 7 and 9 are switched into their switching positions represented in Fig. 4.

In the switching position represented in Fig. 4 the output of the filter 2 is disconnected from the charging filter 4. Furthermore, the output of the charging filter 4 is disconnected both from the attenuating filter 6 and from the input of the discharging filter 8, and the input of the discharging filter 8 is at zero potential. The output of the discharging filter 8 is connected via the switching element 5 to the input of the attenuating filter 6 and via the switching element 9 to the input 11 of the charging filter 4. Consequently the final value of the output of the discharging filter 8 at the end of the discharging cycle is transmitted via the switching element 9 to the input of the charging filter 4, so that the charging cycle immediately following the discharging cycle can start with this starting-value.

Fig. 5 shows a block diagram of a quasi-peak detector 1 according to DE 101 03 481 A1 in a somewhat modified representation. The input-filter block 2 is split up into the input filter 2a and the absolute-value generator 2b connected downstream. Since the charging filter 4 and the discharging filter 8 can be implemented in substantially the same way, these two filters are combined to constitute a filter block 11. The adoption of the final value of the charging filter 4 as starting-value for the discharging filter 8 and, vice versa, the adoption of the final value of the discharging filter 8 as starting-value for the charging filter 4 are carried out internally within the filter block 11. Therefore, a single switch-over element 12 is required at the input of the filter block 11. Also in this exemplary embodiment the detector 10 compares the signal level $X_1$ at the output of the absolute-value generator 2b with the signal level $X_2$ at the input of the attenuating filter 6. If the signal level $X_1$ is greater than the signal level $X_2$, the filter block 11 is switched in such a way that the filter block 11 operates as a charging filter 4. If, on the other hand, the signal level $X_2$ is greater than the signal level $X_1$, the filter block 11 is switched in such a way that the filter block 11 operates as a discharging filter 8. Downstream of the attenuating filter 6 a maximum-value generator' 13 is connected which determines the maximum value of the output signal $S_{out}$.

The configurations shown in Figs. 3 to 5 have the disadvantage that the circuitry is rather complex and that switching between the charging period and the discharging period is necessary. Thus, a specific detector 11 and controller 10 are needed to distinguish between the charging period and the discharging period and to switch the switching elements 3, 7, 9 and 12 accordingly. Further, a specific input filter 2a is necessary in order to compensate negative effects resulting from the switching.

Fig. 6 shows an embodiment of the inventive quasi-peak detector 1 which overcomes these drawbacks. In order to facilitate the comparability with the state of the art embodiment the same reference numbers are used as in Fig. 5. The inventive embodiment comprises a digital charging and discharging filter 11 and an optional digital attenuation filter 6 which is arranged downstream of the digital charging and discharging filter 11. Further, the embodiment shown in Fig. 6 comprises an optional maximum-value generator 13 connected downstream of the attenuation filter 11, which determines the maximum value of the output signal $S_{out}$.

It is an inventive feature that the digital charging and discharging filter 11 simulates charging through an inductor $L_1$. In the block of the digital charging and discharging filter 11 an equivalent circuit with analogue elements having a comparable or similar behaviour of the digital filter 11 is shown. The analogue equivalent circuit comprises a diode $D_1$, the inductor $L_1$ and a first resistor $R_1$ acting as a charging resistor. This serial charging circuit is arranged in series with the capacitor $C_1$. Thus, the digital charging and discharging filter 11 simulates charging through a serial charging circuit comprising the diode $D_1$, the inductor $L_1$ and the first resistor $R_1$. Further, the analogue equivalent circuit comprises a parallel discharging circuit with a second resistor $R_2$ acting as a discharging resistor. This parallel discharging circuit is arranged parallel to the capacitor $C_1$. Thus, the digital charging and discharging filter 11 simulates discharging through a parallel discharging circuit comprising at least the second resistor $R_2$ arranged parallel to the capacitor $C_1$.

The inductor $L_1$ in the analogue equivalent circuit of a digital charging and discharging filter used for a quasi-peak detector is a new and inventive feature never used before. The simulation of the inductor $L_1$ in the charging part avoids that the charging period and discharging period needs to be detected by a detector 10 and further makes the switching elements 3, 7, 9 and 12 dispensable which are necessary in the state of the art embodiment.

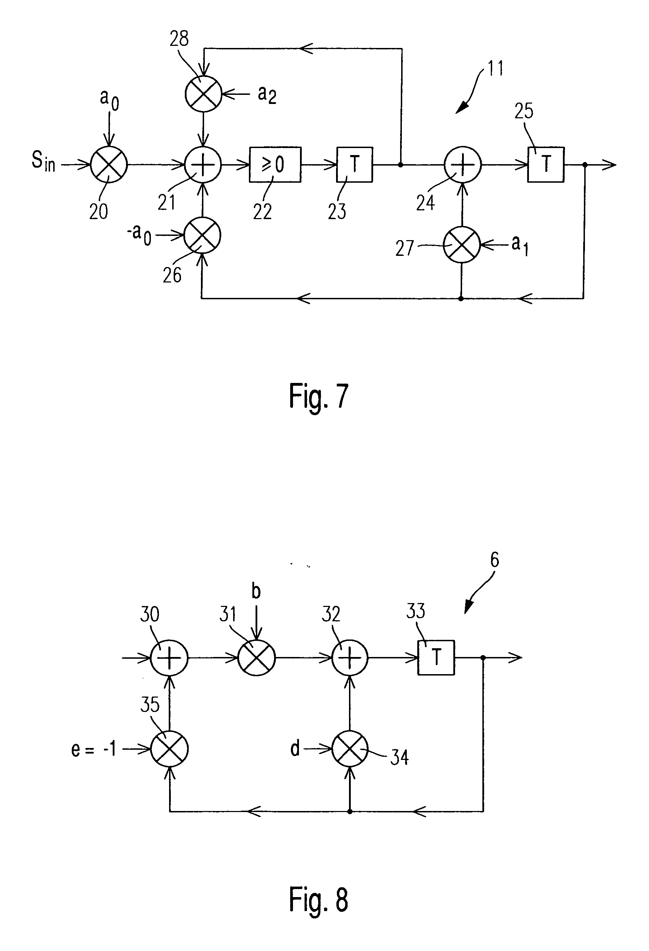

Fig. 7 shows a realisation of the charging and discharging filter 11 in an exemplary embodiment. It should be noted that also other embodiments can be used to realise the simulation of the analogue equivalent circuit shown in the block of the charging and discharging filter 11 in Fig. 6, and thus the scope of the present invention is not limited to a specific embodiment shown in Fig. 7.

In the embodiment of Fig. 7 the digital charging and discharging filter 11 comprises a first multiplier 20 connected to the input node of the digital charging and discharging filter 11 and multiplying its digital input values with a first coefficient $a_0$. A first adder 21 is connected by one of its input terminals (inputs) to the output of the first multiplier 20.

A positive transfer element 22 is connected to the output of the first adder 21. The positive transfer element 22 simulates the behaviour of the diode $D_1$ and transfers only positive output values of the first adder 21 to its output. Output values of the first adder 21 below zero, i.e. negative output values of the first adder 21, are set to zero and are outputted as zero-values. It should be noted that instead of the positive transfer element 22 also a negative transfer element transferring only negative output values of the first adder 21 to its output and setting the other values, i.e. positive values, to zero, could be used. In this case the polarisation of diode $D_1$ in the analogue equivalent circuit shown in Fig. 6 is inversed. This does, however, not influence the basic principle of the circuit.

A first delay element 23 is connected to the output of the positive transfer element 22 and delays the sampled digital values by one sample period, which is equivalent to the clock period of clock rate of the digital filter 11. The second adder 24 is connected with one of its inputs to the output of the first delay element 23. The second delay element 25 is connected to the output of the second adder 24. The second delay element 25 also delays the sampled digital values by one sample period.

The embodiment of the digital charging and discharging filter 11 shown in Fig. 7 further comprises a second multiplier 26 connecting the output of the second delay element 25 with one of the inputs of the first adder 21 and multiplying its input values with the second coefficient $-a_0$. A third multiplier 27 connects the output of the second delay element' 25 with one of the inputs of the second adder 24 and multiplies its digital input values by a first coefficient $a_1$. A fourth multiplier 28 connects the output of the first delay element 23 with one of the inputs of the first adder 21 and multiplies its digital input values by a fourth coefficient $a_2$.

By configuring the coefficients of the multipliers 20, 26, 27 and 28 the behaviour of the digital charging and discharging filter 11 with the embodiment shown in Fig. 7 can be optimised. In a preferred embodiment the first coefficient $a_0$ has the value

$$a_0 = T / ((R_c \cdot C + (L \cdot C / T))) \qquad\qquad (1)$$

wherein T is the delay time of the delay elements 23, 25, $R_c$ is the resistance value of the first resistor (charging resistor) $R_1$, C is the capacitance value of the capacitor $C_1$ and L is the inductance value of the inductor $L_1$. Further in the preferred embodiment the second coefficient $-a_0$ has the negative value of the first coefficient $a_0$.

Further, in the preferred embodiment the third coefficient $a_1$ has the value

$$a_1 = 1 - (T / (R_D \cdot C)) \qquad\qquad (2)$$

wherein $R_D$ is the resistance value of the second resistor (discharging resistor) $R_2$.

Further, in the preferred embodiment the fourth coefficient $a_2$ has the value

$$a_2 = -L / (L + R_c \cdot T). \qquad\qquad (3)$$

It should be noted that because of the optimised behaviour of the digital charging and discharging filter 11 the input filter 2, which is necessary in the state of the art embodiment of Fig. 5, is not necessary for the inventive embodiment as shown in Fig. 6.

Fig. 8 shows a preferred embodiment of the optional digital attenuation filter 6, which is arranged downstream of the digital charging and discharging filter 11 and simulates the attenuation response of the measuring instrument. It should be noted that the embodiment shown in Fig. 8 only shows the preferred embodiment and that other embodiments of this filter are also possible. Thus, the scope of the present invention is not limited to the specific embodiment shown in Fig. 8.

In the embodiment of Fig. 8 the digital attenuation filter 6 comprises a first adder 30 with one of its inputs connected to the input node of the attenuation filter 6 which preferably is the output node of the charging and discharging filter 11. A first multiplier 31 is connected to the output of the first adder 30 and multiplies its digital input values by a first coefficient b. A second adder 32 is connected with one of its inputs to the output of the first multiplier 31. A delay element 33 is connected to the output of the second adder 32. The delay element 33 delays the digital sampled values by one sample period, which is equivalent to the clock period of the clock rate of the digital filter.

In the preferred embodiment shown in Fig. 8 the digital attenuation filter 6 further comprises a second multiplier 34 connecting the output of the delay element 33 with one of the inputs of the second adder 32 and multiplying its digital input values by a second coefficient d. Further, a third multiplier 35 connects the output of the delay element 33 with one of the inputs of the first adder 30 and multiplies its digital input values by a third coefficient e.

The behaviour of the preferred embodiment of the digital attenuation filter 6 as shown in Fig. 8 can be optimised by using specific values for the coefficients of the multipliers 31, 34 and 35. According to a preferred embodiment the second coefficient d has a positive value closed to but not equal to zero and is preferably in the range between 0 and 0.0001. The first coefficient b is calculated from the second coefficient d as follows:

$$b = 1 - d. \qquad\qquad (4)$$

The third coefficient is preferably identical with -1:

$$e = -1 \qquad\qquad (5)$$

It should be noted that the scope of the present invention is not limited to the embodiments shown in the drawings and described above. All described elements can be combined individually.

**Claims**

1.  A quasi-peak detector (1) for detecting the weighted peak value (quasi peak) of the envelope of a signal ($S_{in}$) comprising a digital charging and discharging filter (11) which simulates the process of charging and discharging a capacitor ($C_1$),
    **characterised in that**
    the digital charging and discharging filter (11) simulates charging through an inductor ($L_1$).

2.  A quasi-peak detector according to claim 1,
    **characterised in that**
    the digital charging and discharging filter (11) simulates charging through a serial charging circuit comprising at least a diode ($D_1$), the inductor ($L_1$) and a first resistor ($R_1$), whereby the serial charging circuit is arranged in series with the capacitor ($C_1$).

3.  A quasi-peak detector according to claim 2,
    **characterised in that**
    the digital charging and discharging filter (11) simulates discharging through a parallel discharging circuit comprising at least a second resistor ($R_2$), whereby the parallel discharging circuit is arranged parallel to the capacitor ($C_1$).

4.  A quasi-peak detector according to claim 3,
    **characterised in that**
    the digital charging and discharging filter (11) comprises a first multiplier (20) connected to the input node of the digital charging and discharging filter (11) and multiplying its input values by a first coefficient ($a_0$),
    a first adder (21) with one of its inputs connected to the output of the first multiplier (20),
    a positive or negative transfer element (22) transferring only positive or negative output values of the first adder (21) and setting the other output values to zero,
    a first delay element (23) connected to the output of the positive or negative transfer element (22),
    a second adder (24) with one of its inputs connected to the output of the first delay element (23) and
    a second delay element (25) connected to the output of the second adder (24).

5.  A quasi-peak detector according to claim 4,
    **characterised in that**
    the digital charging and discharging filter (11) further comprises
    a second multiplier (26) connecting the output of the second delay element (25) with one of the inputs of the first adder (21) and multiplying its input values by a second coefficient ($-a_0$),
    a third multiplier (27) connecting the output of the second delay element (25) with one of the inputs of the second adder (24) and multiplying its input values by a third coefficient ($a_1$) and
    a fourth multiplier (28) connecting the output of the first delay element (23) with one of the inputs of the first adder (21) and multiplying its input values by a fourth coefficient ($a_2$).

6.  A quasi-peak detector according to claim 5,
    **characterised in that**
    the first coefficient $a_0$ has the value

$$a_0 \;=\; T/((R_c \cdot C + (L \cdot C / T)))$$

    wherein

    T is the delay time of the delay elements (23, 25)
    $R_c$ is the resistance value of the first resistor ($R_1$)
    C is the capacitance value of the capacitor ($C_1$) and
    L is the inductance value of the inductor ($L_1$).

7.  A quasi-peak detector according to claim 6,
    **characterised in that**
    the second coefficient $-a_0$ has the negative value of the first coefficient $a_0$.

**8.** A quasi-peak detector according to claim 6 or 7,
**characterised in that**
the third coefficient $a_1$ has the value

$$a_1 = 1-(T/(R_D \cdot C))$$

wherein

$R_D$ is the resistance value of the second resistor ($R_2$).

**9.** A quasi-peak detector according to any of claims 6 to 8,
**characterised in that**
the forth coefficient $a_2$ has the value

$$a_2 = -L/(L+R_c \cdot T).$$

**10.** A quasi-peak detector according to any of claims 1 to 9,
**characterised in that**
a digital attenuation filter (6) is arranged downstream of the digital charging and discharging filter (11) which simulates the attenuation response of a measuring instrument.

**11.** A quasi-peak detector according to claim 10,
**characterised in that**
the digital attenuation filter (6) comprises
a first adder (30) with one of its inputs connected to the input node of the attenuation filter (6),
a first multiplier (31) connected to the output of the first adder (30) and multiplying its input values by a first coefficient (b),
a second adder (32) with one of its inputs connected to the output of the first multiplier (31) and
a delay element (33) connected to the output of the second adder (32).

**12.** A quasi-peak detector according to claim 11,
**characterised in that**
the digital attenuation filter (6) further comprises
a second multiplier (34) connecting the output of the delay element (33) with one of the inputs of the second adder (32) and multiplying its input values by a second coefficient (d) and
a third multiplier (35) connecting the output of the delay element (33) with one of the inputs of the first adder (30) and multiplying its input values by a third coefficient (e).

**13.** A quasi-peak detector according to claim 12,
**characterised in that**
the second coefficient d has a positive value close to zero and is preferably in the range between 0 and 0.0001.

**14.** A quasi-peak detector according to claim 12 or 13,
**characterised in that**
the first coefficient b is calculated from the second coefficient d as

$$b = 1-d.$$

**15.** A quasi-peak detector according to any of claims 12 to 14,
**characterised in that**
the third coefficient e is

$$e = -1.$$

Fig. 1

(State of the Art)

Fig. 2

**Fig. 3**

(State of the Art)

**Fig. 4**

(State of the Art)

# Fig. 5

(State of the Art)

# Fig. 6

Fig. 7

Fig. 8

**European Patent Office**

## EUROPEAN SEARCH REPORT

Application Number

EP 04 02 1457

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,Y | DE 101 03 481 A1 (ROHDE & SCHWARZ GMBH & CO. KG) 14 August 2002 (2002-08-14) * abstract; figures 1,5-7 * ----- | 1-15 | G01R19/25 |
| Y | LOZE M K ET AL: "Computer model for analysing digital magnetic recording systems" IEE PROCEEDINGS : COMMUNICATIONS, INSTITUTION OF ELECTRICAL ENGINEERS, GB, vol. 144, no. 5, 14 October 1997 (1997-10-14), pages 289-294, XP006008483 ISSN: 1350-2425 * abstract * * paragraphs [02.2] - [02.4]; figures 3,5 * ----- | 1-15 | |

**TECHNICAL FIELDS SEARCHED (Int.Cl.7)**

G01R

The present search report has been drawn up for all claims

| Place of search | Date of completion of the search | Examiner |
|---|---|---|
| Berlin | 9 February 2005 | Binger, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

&: member of the same patent family, corresponding document

EPO FORM 1503 03.82 (P04C01)

## ANNEX TO THE EUROPEAN SEARCH REPORT
## ON EUROPEAN PATENT APPLICATION NO.

EP 04 02 1457

This annex lists the patent family members relating to the patent documents cited in  the above-mentioned European search report.
The members are as contained in the European Patent Office EDP file on
The European Patent Office is in no way  liable for these particulars which are merely  given for the purpose of information.

09-02-2005

| Patent document cited in search report | Publication date | Patent family member(s) | Publication date |
|---|---|---|---|
| DE 10103481 A1 | 14-08-2002 | JP 2002350474 A | 04-12-2002 |

EPO FORM P0459

For more details about this annex : see Official Journal of the European Patent Office, No. 12/82